(19) Europäisches Patentamt
European Patent Office
Office européen des brevets

(11) EP 1 722 605 A1

(12) **EUROPEAN PATENT APPLICATION**
published in accordance with Art. 158(3) EPC

(43) Date of publication:
**15.11.2006 Bulletin 2006/46**

(21) Application number: **05720005.7**

(22) Date of filing: **04.03.2005**

(51) Int Cl.:
***H05B 33/24*** (2006.01) ***H05B 33/12*** (2006.01)
***H05B 33/14*** (2006.01)

(86) International application number:
**PCT/JP2005/003733**

(87) International publication number:
**WO 2005/086540 (15.09.2005 Gazette 2005/37)**

(84) Designated Contracting States:
**AT BE BG CH CY CZ DE DK EE ES FI FR GB GR HU IE IS IT LI LT LU MC NL PL PT RO SE SI SK TR**

(30) Priority: **05.03.2004 JP 2004061685**

(71) Applicant: **IDEMITSU KOSAN CO., LTD.**
**Tokyo 100-8321 (JP)**

(72) Inventors:
- **FUKUOKA, Kenichi**
  **2990293 (JP)**
- **YUASA, Kimihiro**
  **2990293 (JP)**
- **HOSOKAWA, Chishio**
  **2990293 (JP)**

(74) Representative: **Gille, Christian**
**Gille Hrabal Struck Neidlein Prop Roos**
**Brucknerstrasse 20**
**40593 Düsseldorf (DE)**

(54) **ORGANIC ELECTROLUMINESCENCE ELEMENT AND DISPLAY**

(57) An organic electroluminescent device including: a light reflecting layer (1), a light semi-transmitting layer (3) and a light interference part (2) including an organic emitting layer, the part being formed between the light reflecting layer (1) and the light semi-transmitting layer (3); the spectrum of reflected light (B) having at least three minimum values in the wavelength region of 400 to 800 nm when light (A) having a wavelength of 400 to 800 nm enters from the light semi-transmitting layer (1). Incident light (A) is reflected in the light interference part (B) and undergoes optical interference effects. At this time, it is possible to cause the spectrum of light emitted to the outside to have a certain sharpened wavelength peak by adjusting the optical path length of the light interference part (2). As a result, the color purity is improved.

FIG.1

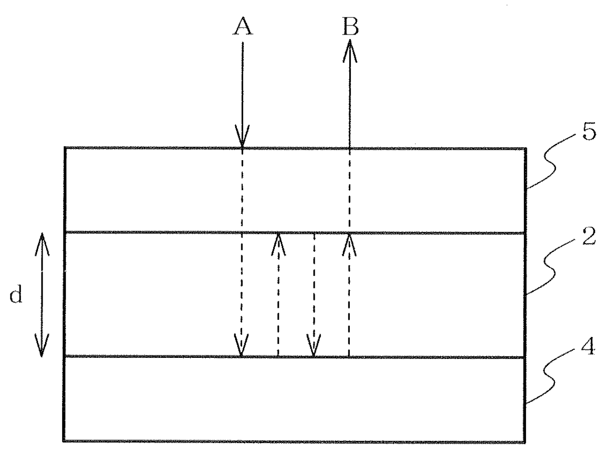


EP 1 722 605 A1

## Description

Technical Field

The invention relates to an organic electroluminescent (EL) device. In particular, the invention relates to a white organic EL device.

Background Art

An organic EL device has been expected as a next-generation flat display due to self-emitting properties and the like. As a full-color display method, a three-color pattern formation method, a color changing medium (CCM) method, and a white color filter (CF) method have been proposed. A method suitable for a large-screen display has not been necessarily determined.

The three-color pattern formation method, which is relatively widely used at present and utilizes a high-definition deposition mask, has a problem in forming a large-screen display. On the other hand, since the white CF method does not require a high-definition deposition mask and allows utilization of a CF used for an LCD, the white CF method is expected as a method of forming a large-screen organic EL display.

However, a conventional white CF method has a problem relating to the color reproducibility of the display. This is because it is generally difficult to obtain an organic EL emission spectrum with a small half-width. The organic EL obtains white light by mixing the colors of light from organic materials which emit light of different colors. When causing such white light to pass through a color filter, the color purity of the light deteriorates after passing through the color filter due to a large half-width. The color purity can be improved by adjusting the color filter. However, the amount of light passing through the color filter decreases, whereby power consumption increases.

An attempt has been made to utilize optical interference for an organic EL device. For example, when using an organic EL device in which a first electrode formed of a light reflecting material, an organic layer including an organic emitting layer, a semitransparent reflecting layer, and a second electrode formed of a transparent material are stacked such that the organic layer serves as a resonator, the optical length L is adjusted to be minimized within the range in which "$(2L)/\lambda+\varphi/(2\Pi) = m$ is satisfied wherein m is an integer, $\varphi$ is a phase shift, and $\lambda$ is the peak wavelength of the spectrum of light to be outcoupled (see patent document 1). In a structure in which an organic EL layer is placed between a light reflecting layer and a transparent layer, each of R, G, and B pixels has a color filter disposed on the light-outcoupling side or the external light incident side of the transparent layer (see patent document 2).

However, the above devices have the following problems. (1) Since the actual thickness which satisfies the above expression must be considerably reduced in comparison with a general organic EL device, a conduction failure tends to occur, or the actual thickness may differ from the thickness optimum for the organic emitting material from the viewpoint of luminous efficiency. (2) In order to form a full-color device, it is necessary to form the device to have a thickness corresponding to each color in pixel units, thereby making production difficult. (3) The light selectivity may be insufficient since conditions where the order m is small are utilized.

Patent document 1: WO2001/039554
Patent document 2: JP-A-H14-373776

The invention provides an organic EL device and display excel in color purity.

Disclosure of the Invention

The inventors found that light repeatedly reflected between two reflective surfaces can have three or more wavelength properties in the visible region by adjusting the optical path length defined by the two reflective surfaces to a certain value, and completed the invention.

The invention provides the following organic EL device and display.

1. An organic electroluminescent device comprising a light reflecting layer, a light semi-transmitting layer and a light interference part including an organic emitting layer, the part being formed between the light reflecting layer and the light semi-transmitting layer; the spectrum of reflected light emitted from the light semi-transmitting layer having at least three minimum values in the wavelength region of 400 to 800 nm when light having a wavelength of 400 to 800 nm enters from the light semi-transmitting layer.
2. The organic electroluminescent device according to 1, wherein at least one of the light reflecting layer and the light semi-transmitting layer is a drive electrode.

3. The organic electroluminescent device according to 1 or 2, wherein the light reflecting layer is a reflective electrode.
4. The organic electroluminescent device according to any one of 1 to 3, wherein the light interference part comprises at least one of, a first inorganic compound layer between the light reflecting layer and the organic emitting layer and, a second inorganic compound layer between the organic emitting layer and the light semi-transmitting layer.
5. The organic electroluminescent device according to 4, wherein at least one of the first and second inorganic compound layers is a transparent electrode.
6. The organic electroluminescent device according to any one of 1 to 5, wherein the light semi-transmitting layer is provided with a light diffusion part.
7. An organic electroluminescent device comprising: a first light semi-transmitting layer, a second light semi-transmitting layer and a light interference part including an organic emitting layer, the part being formed between the first light semi-transmitting layer and the second light semi-transmitting layer; the spectrum of transmitted light emitted from the first light semi-transmitting layer having at least three maximum values in the wavelength region of 400 to 800 nm when light having a wavelength of 400 to 800 nm enters from the second light semi-transmitting layer.
8. The organic electroluminescent device according to 7, wherein at least one of the first light semi-transmitting layer and the second light semi-transmitting layer is a drive electrode.
9. The organic electroluminescent device according to 7 or 8, wherein the light interference part comprises at least one of, a first inorganic compound layer between the first light semi-transmitting layer and the organic emitting layer and, a second inorganic compound layer between the organic emitting layer and the second light semi-transmitting layer.
10. The organic electroluminescent device according to 9, wherein at least one of the first and second inorganic compound layers is a transparent electrode.
11. The organic electroluminescent device according to any one of 7 to 10, wherein at least one of the first and second light semi-transmitting layers is provided with a light diffusion part.
12. A display comprising a color conversion member and the organic electroluminescent device according to any one of 1 to 11.
13. A display comprising a color filter and the organic electroluminescent device according to any one of 1 to 11.

Incident light is reflected in the light interference part and undergoes optical interference effects. At this time, it is possible to cause the spectrum of light emitted to the outside to have a certain wavelength peak by adjusting the optical path length of the light interference part. In addition, the certain wavelength peak can be more sharpened. As a result, the color purity is improved. The use of a color conversion member or color filter further improves the color purity. For example, when it is intended to outcouple light of three colors by using color filters, light excel in color purity can be obtained since a device has been previously formed such that the three colors are emphasized in its spectrum.
Accordingly, the invention can provide an organic EL device and display excel in color purity. The organic EL device can be easily fabricated since the entire devices have the same configuration and thickness.

Brief Description of Drawings

Fig. 1 is a view showing an organic EL device according to First embodiment.
Fig. 2 is a graph showing the spectrum of reflected light from the organic EL device according to First embodiment.
Fig. 3(a) is a graph showing the white emission spectrum of an organic emitting layer.
Fig. 3(b) is a graph showing light reflection characteristics when a device is not driven.
Fig. 3(c) is a graph showing the spectrum of light emitted to the outside from a device.
Fig. 4a is a view showing one example of the organic EL device configuration.
Fig. 4b is a view showing another example of the organic EL device configuration.
Fig. 4c is a view showing another example of the organic EL device configuration.
Fig. 4d is a view showing another example of the organic EL device configuration.
Fig. 4e is a view showing another example of the organic EL device configuration.
Fig. 4f is a view showing another example of the organic EL device configuration.
Fig. 4g is a view showing another example of the organic EL device configuration.
Fig. 4h is a view showing another example of the organic EL device configuration.
Fig. 4i is a view showing another example of the organic EL device configuration.
Fig. 4j is a view showing another example of the organic EL device configuration.
Fig. 4k is a view showing another example of the organic EL device configuration.
Fig 5 is a view showing an organic EL device according to Second embodiment.
Fig. 6 is a graph showing the spectrum of transmitted light from the organic EL device according to Second embodiment.

Fig. 7a is a view showing an organic EL device fabricated in Example 1.

Fig. 7b is a view showing an organic EL device fabricated in Comparative example 1.

Fig. 7c is a view showing an organic EL device fabricated in Example 2.

Fig. 7d is a view showing an organic EL device fabricated in Comparative example 2.

## Preferred Embodiments of the Invention

### First embodiment

FIG. 1 is a view showing an organic EL device according to one embodiment of the invention, and FIG. 2 is a graph showing the spectrum of reflected light from the organic EL device.
The organic EL device includes a light reflecting layer 1, a light interference part 2, and a light semi-transmitting layer 3 stacked in that order. When light with a wavelength of 400 to 800 nm enters the unenergized device through the light semi-transmitting layer 3, as indicated by the arrow A, the light is reflected by the light reflecting layer 1 and emitted through the light semi-transmitting layer 3, as indicated by the arrow B. In this case, the light is repeatedly reflected inside the light interference part 2 and undergoes optical interference effects, whereby the spectrum of the reflected light has at least three minimum values in the wavelength region of 400 to 800 nm, as shown in FIG. 2. The spectrum of the reflected light preferably has at least three peaks with a half-width of 150 nm or less.

In the organic EL device, light emitted is repeatedly reflected between two light reflecting surfaces (indicated by d in FIG. 1), and light with a wavelength λ satisfying the following expression is enhanced and emitted to the outside of the device.

$$2L/(\lambda/2) = m \text{ (m is an integer of 0 or more)}$$

$$L = nd$$

(L indicates the optical length, d indicates the film thickness, n indicates the refractive index of the member provided between two light reflecting surfaces, and λ indicates the wavelength of light)

Therefore, the spectrum of light from the device appears as a result of synergistic effects of the emission spectrum specific to the EL material and the transmission characteristics due to the interference effects. It is possible to provide selectivity for three or more wavelengths in the visible region by providing a specific optical length (optical path length) L.

The effects of interference between two light reflecting surfaces may be confirmed without applying current to the organic EL device. Specifically, light is caused to enter the display surface of the device from the outside, and the wavelength dependence of the light absorption of the device is measured. In this embodiment, the reflection spectrum is measured. The reflection spectrum has characteristics almost reverse to the light transmission characteristics of the device for internal EL emission. Therefore, when an absorption peak exists, it can be determined that the EL light is selectively transmitted at that wavelength.

The reflection spectrum may be measured by applying monochromatic light while sequentially changing the wavelength in the region of 400 to 800 nm, and measuring the reflection intensity at that wavelengths, for example.

In this embodiment, three or more absorption peaks can be obtained by adjusting the thickness (optical path length) of the light interference part 2 provided between the light reflecting layer 1 and the light semi-transmitting layer 3. The thickness of the light interference part 2 is preferably 100 to 1000 nm.

It is preferable to stack a color conversion member or a color filter on the light-outcoupling side of the device in order to allow the device to emit light of a plurality of colors (multicolor device). As the color conversion member, a fluorescent member which converts part of the received light into light with a different wavelength may be used. The color conversion member and the color filter may be used in combination.

As the color filter, a generally-used color filter may be used. Since this device can be provided in advance with the emission spectrum matching the transmission characteristics of a color filter, light of an extremely pure color can be emitted in comparison with the case of stacking a color filter on a general device.

A light diffusion part may be stacked on the light semi-transmitting layer 3 in order to improve the viewing angle characteristics. As the light diffusion part, any means used for a liquid crystal display, an organic EL display, and the like may be used, such as a transparent plate provided with a number of minute grooves or holes in its surface, a transparent plate in which minute bubbles or particles are dispersed, or a transparent plate in which a microprism is formed on its surface.

When forming a multicolor device using the color conversion member or the color filter, it is effective to dispose the light diffusion part outside the color conversion member or the color filter in the opposite direction to the device. Note that the color conversion member or the color filter layer may be processed as described above to integrate the light diffusion part into the color conversion member or the color filter layer.

When the emission spectrum of the organic emitting layer is white, a full-color device may be realized using a simple configuration by adjusting the optical path length so that the emission spectrum has three maximum values corresponding to red, green, and blue. FIG. 3(a) shows the white emission spectrum of the organic emitting layer, and FIG. 3(b) shows the light transmission characteristics of the device, in which the reflection spectrum measured without operating the device is illustrated. FIG. 3(b) indicates that the absorption maximum values exist at 470 nm, 550 nm, and 620 nm, and light emitted in the device is selectively transmitted at these wavelengths. As a result, when applying current to the device, the spectrum of light emitted to the outside of the device from the reflection side has the maximum values of the three primary colors, as shown in FIG. 3(c). A device exhibiting particularly excellent color reproducibility is obtained by combining the device with a color filter. As described above, the maximum values of the three primary colors are obtained by merely adjusting the optical path length. As a result, light with an extremely high color purity can be efficiently outcoupled.

In this embodiment, the optical path length is adjusted by changing the thickness of the light interference part 2, that is, the type and thickness of the layers which forms the light interference part 2. The light interference part 2 includes at least an organic emitting layer. The thickness of the light interference part 2 may be adjusted by stacking an organic compound layer and/or an inorganic compound other than the organic emitting layer.

FIGS. 4a to 4k illustrate specific examples of the device configuration.
In FIGS. 4a to 4k, a portion placed above a substrate 40 between a metal film 41 (light reflecting layer) and a light semi-transmitting metal film 42 (light semi-transmitting layer) is the light interference part. The light interference part includes an organic layer 43 including an organic emitting layer and a non-emitting inorganic compound layer (first and/or second inorganic compound layer) described below. As shown in FIGS. 4a and 4b, light-transmitting electrodes 45 and 45b (non-emitting inorganic compound layers) may be provided to protect the light semi-transmitting metal film 42.

As shown in FIGS. 4a to 4k, the light interference part may be configured as follows, for example.

FIG. 4a: organic layer 43
FIG. 4b: first light-transmitting electrode 45a (first inorganic compound layer) / organic layer 43
FIG. 4c: first light-transmitting electrode 45a (first inorganic compound layer) / organic layer 43 / second light-transmitting electrode 45b (second inorganic compound layer)
FIG. 4d: first light-transmitting electrode 45a (first inorganic compound layer) / hole transporting layer 46 (first inorganic compound layer) / organic layer 43 / second light-transmitting electrode 45b (second inorganic compound layer)
FIG. 4e: first light-transmitting electrode 45a (first inorganic compound layer) / organic layer 43 / electron transporting layer 47 (second inorganic compound layer) / second light-transmitting electrode 45b (second inorganic compound layer)
FIG. 4f: first light-transmitting electrode 45a (first inorganic compound layer) / hole transporting layer 46 (first inorganic compound layer) / organic layer 43 / electron transporting layer 47 (second inorganic compound layer) / second light-transmitting electrode 45b (second inorganic compound layer)
FIG. 4g: first light-transmitting electrode 45a (first inorganic compound layer) / hole injecting layer 48 (first inorganic compound layer) / hole transporting layer 46 (first inorganic compound layer) / organic layer 43 / electron transporting layer 47 (second inorganic compound layer) / second light-transmitting electrode 45b (second inorganic compound layer)
FIG. 4h: organic layer 43 / light-transmitting electrode 45 (second inorganic compound layer) / sealing layer 49 (second inorganic compound layer)
FIG. 4i: first light-transmitting electrode 45a (first inorganic compound layer) / organic layer 43 / second light-transmitting electrode 45b (second inorganic compound layer) / sealing layer 49 (second inorganic compound layer)
FIG. 4j: organic layer 43a / light-transmitting electrode 45 (first inorganic compound layer or second inorganic compound layer) / organic layer 43b
FIG. 4k: first light-transmitting electrode 45a (first inorganic compound layer) / organic layer 43a / second light-transmitting electrode 45b (first inorganic compound layer or second inorganic compound layer) / organic layer 43b / third light-transmitting electrode 45c (second inorganic compound layer)

The hole injecting layer, hole transporting layer, electron transporting layer, and electron injecting layer shown in FIGS. 4a to 4k are formed of an inorganic compound and correspond to the first and second inorganic compound layers. Note that these layers may be formed of an organic compound, as described later. In this case, these layers form part of the organic layer.

In FIGS. 4a to 4k, the electrode includes not only a low-resistivity metal, but also a semiconductor or a high-resistivity substance. The light-transmitting electrode is not particularly limited insofar as the light-transmitting electrode transmits light. When disposing the light-transmitting electrode between two light reflecting layers, as shown in FIGS. 4j and 4k, the light-transmitting electrode preferably has a refractive index close to that of the organic layer (e.g. molybdenum oxide).

The organic layer is not particularly limited insofar as the organic layer includes the organic emitting layer. The organic layer may be either a fluorescence type or a phosphorescence type exhibiting a higher luminous efficiency. It is a common practice to stack or mix a plurality of organic materials in order to obtain an organic EL device exhibiting a higher performance. For example, the following configurations may be employed. Note that the configuration of the organic layer is not limited thereto.
Organic emitting layer
Hole transporting layer / organic emitting layer
Organic emitting layer / electron transporting layer
Hole transporting layer / organic emitting layer / electron transporting layer
Hole injecting layer / hole transporting layer / organic emitting layer / electron transporting layer
Hole injecting layer / hole transporting layer / organic emitting layer / electron transporting layer / electron injecting layer
Each layer may be a single layer or may include a plurality of layers.

FIGS. 4a to 4k illustrate the top-emission type device configurations. A bottom-emission type device configuration may also be formed by disposing a transparent substrate on the light semi-transmitting layer. The inorganic compound layer shown in FIGS. 4a to 4k may function as the hole injecting layer, hole transporting layer, electron transporting layer, or electron injecting layer separately from the above organic layer.

Second embodiment

FIG. 5 is a view showing an organic EL device according to another embodiment of the invention.
The organic EL device includes a first light semi-transmitting layer 4, the light interference part 2, and a second light semi-transmitting layer 5 stacked in that order. When light with a wavelength of 400 to 800 nm enters the unenergized device through the first light semi-transmitting layer 5, as indicated by the arrow A, the light passes through the second light semi-transmitting layer 4 and is emitted to the outside of the device, as indicated by the arrow C. In this case, the light is repeatedly reflected inside the light interference part 2 and undergoes optical interference effects, whereby the spectrum of the transmitted light has at least three maximum values in the wavelength region of 400 to 800 nm, as shown in FIG. 6. The spectrum of the transmitted light preferably has at least three maximum peaks with a half-width of 150 nm or less. In this case, the spectrum of the transmitted light has characteristics almost reverse to the characteristics when measuring the reflected light from the second light semi-transmitting layer 5. Specifically, the spectrum of the reflected light has at least three minimum values in the wavelength region of 400 to 800 nm.

In this embodiment, three or more maximum peaks may be obtained for the transmitted light by adjusting the thickness (optical path length) of the light interference part 2 provided between the first light semi-transmitting layer 4 and the second light semi-transmitting layer 5 like the first embodiment. The thickness of the light interference part 2 is preferably 100 to 1000 nm. This maximum peak characteristics allow light with these wavelengths to be selectively emitted when applying current to the device, whereby the color purity is improved.
The configurations of the color conversion member, light diffusion part, white emission, and light interference part and the like are the same as in the first embodiment.

Each member is described below. Note that the configuration of each member is not limited to the following description. Specifically, a known material may be selectively used for each member in addition to the material given in the following description.

(1) Light reflecting layer and light semi-transmitting layer

A layer which transmits part of the light (light semi-transmitting layer) is used for at least one of the two layers in order to outcouple light for use. As the material for these layers, an inorganic compound exhibiting transparency and having a refractive index higher than that of a metal or the organic layer may be utilized. When using a metal, specular reflection occurs due to the metal surface. When using an inorganic compound having a refractive index higher than that of the organic layer, reflection of light occurs corresponding to the magnitude of the difference in refractive index. When forming at least one of the layers as a light semi-transmitting layer, the thickness of the layer is reduced or the difference in refractive index is adjusted. Specific examples are given below.

(a) Light reflecting metal layer

The light reflecting metal layer is not particularly limited insofar as the light reflecting metal layer can efficiently reflect visible light. The light reflecting metal layer may have a function of injecting electrons or holes into the organic layer. Note that the light reflecting metal layer need not necessarily have this function. Electrons or holes may be injected into the organic layer using a hole injecting layer or an electron injecting layer. As examples of such a material, a material selected from Al, Ag, Au, Pt, Cu, Mg, Cr, Mo, W, Ta, Nb, Li, Mn, Ca, Yb, Ti, Ir, Be, Hf, Eu, Sr, and Ba, and an alloy of these elements can be given.

(b) Light semi-transmitting metal layer

A metal generally exhibits a low visible light transmittance. On the other hand, a certain substance can transmit visible light by reducing the film thickness. As examples of such a material, the above metals and alloys can be given.

(c) Inorganic compound

The inorganic compound is not particularly limited insofar as the inorganic compound has a refractive index higher than that of the organic layer. As examples of the inorganic compound, metal oxides of In, Sn, Zn, Cd, Ti, and the like, high-refractive-index ceramic materials, inorganic semiconductor materials, and the like can be given. A resin in which ultrafine particles such as titania are dispersed may also be used.

(2) Light-transmitting electrode

The light-transmitting electrode is used to increase the optical path length as part of the light interference part, apply the drive voltage to the organic emitting layer, and/or protect the adjacent light reflecting layer or light semi-transmitting layer mechanically or during the production process. The thickness of the light-transmitting electrode is appropriately adjusted depending the objective. As the material for the light-transmitting electrode, a light-transmitting material, as used for the anode or the cathode, is used.
When the light-transmitting electrode is used to apply the drive voltage to the organic emitting layer, the light-transmitting electrode functions as the anode or the cathode or part of the anode or the cathode. The light-transmitting electrode need not necessarily function as the anode or the cathode. The light reflecting layer or the light semi-transmitting layer may function as the anode or the cathode or part of the anode or the cathode. A member other than the light-transmitting electrode, the light reflecting layer, and the light semi-transmitting layer may be provided as the anode or the cathode or part of the anode or the cathode.

(3) Anode

It is preferable that the anode has a work function of 4.5 eV or more. As examples of the anode, indium tin oxide (ITO), indium zinc oxide (IZO), tin oxide (NESA), gold, silver, platinum, copper and the like can be given. Of these, indium zinc oxide (IZO) is particularly preferable, since IZO film can be formed at room temperature and is highly amorphous so that separation of the anode hardly occurs.
The sheet resistance of the anode is preferably 1000 Ω/□ or less, more preferably 800 Ω/□ or less, even more preferably 500 Ω/□ or less.
When luminescence is outcoupled from the anode, the transmittance of the anode to luminescence is preferably 10% or more, more preferably 30% or more, even more preferably 50% or more.
Although the optimal value of the film thickness of the anode is dependent on the material thereof, the thickness is selected generally from 10 nm to 1 μm, preferably 10 nm to 200 nm.

(4) Cathode

For the cathode, the following may be preferred: an electrode substance made of a metal, an alloy or an electroconductive compound, or a mixture thereof which has a small work function (4 eV or less). Specific examples of the electrode substance include sodium, sodium-potassium alloy, magnesium, lithium, magnesium/silver alloy, aluminum/aluminum oxide, aluminum/lithium alloy, indium, and rare earth metals.
The cathode can be formed by making the electrode substance(s) into a thin film by vapor deposition, sputtering or some other method.
In the case where luminescence from the organic emitting layer is outcoupled through the cathode, the transmittance of the cathode to luminescence is preferably 10% or more.

The sheet resistance of the cathode is preferably several hundreds Ω/□ or less. The film thickness of the cathode is generally 10 nm to 1 μm, preferably from 50 to 200 nm.

(5) Organic emitting layer

As methods of forming the organic emitting layer, known methods such as vacuum deposition, spin coating and LB technique can be applied. As disclosed in JP-A-57-51781, the organic emitting layer can also be formed by dissolving a binder such as resins and material compound in a solvent to make a solution and forming a thin film therefrom by spin coating and so on.

The materials used in the organic emitting layer may be a material known as a luminescent material having a long lifetime. Fluorescent or phosphorescent materials may be used. Phosphorescent materials are preferred due to their excellent luminous efficiency.

As an example, fluorescent materials will be described below. It is preferred to use, as the material of the luminescent material, a material represented by a formula (1) .

$$(Ar^1)_l(X)_m \qquad (1)$$

wherein $Ar^1$ is an aromatic ring with 6 to 50 nucleus carbon atoms, X is a substituent, 1 is an integer of 1 to 5, and m is an integer of 0 to 6.

Specific examples of $Ar^1$ include phenyl, naphthyl, anthracene, biphenylene, azulene, acenaphthylene, fluorene, phenanthrene, fluoranthene, acephenanthrylene, triphenylene, pyrene, chrysene, naphthacene, picene, perylene, penthaphene, pentacene, tetraphenylene, hexaphene, hexacene, rubicene, coronene, and trinaphthylene rings.

Preferred examples thereof include phenyl, naphthyl, anthracene, acenaphthylene, fluorene, phenanthrene, fluoranthene, triphenylene, pyrene, chrysene, perylene, and trinaphthylene rings.

More preferred examples thereof include phenyl, naphthyl, anthracene, fluorene, phenanthrene, fluoranthene, pyrene, chrysene, and perylene rings.

Specific examples of X include substituted or unsubstituted aromatic groups with 6 to 50 nucleus carbon atoms, substituted or unsubstituted aromatic heterocyclic groups with 5 to 50 nucleus carbon atoms, substituted or unsubstituted alkyl groups with 1 to 50 carbon atoms, substituted or unsubstituted alkoxy groups with 1 to 50 carbon atoms, substituted or unsubstituted aralkyl groups with 1 to 50 carbon atoms, substituted or unsubstituted aryloxy groups with 5 to 50 nucleus atoms, substituted or unsubstituted arylthio groups with 5 to 50 nucleus atoms, substituted or unsubstituted carboxyl groups with 1 to 50 carbon atoms, substituted or unsubstituted styryl groups, halogen groups, a cyano group, a nitro group, and a hydroxyl group.

Examples of the substituted or unsubstituted aromatic groups with 6 to 50 nucleus carbon atoms include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-fluorenyl, 9,9-dimethyl-2-fluorenyl and 3-fluorantenyl groups.

Preferred examples thereof include phenyl, 1-naphthyl, 2-naphthyl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, o-tolyl, m-tolyl, p-tolyl, p-t-butylphenyl, 2-fluorenyl, 9,9-dimethyl-2-fluorenyl and 3-fluorantenyl groups.

Examples of the substituted or unsubstituted aromatic heterocyclic groups with 5 to 50 nucleus carbon atoms include 1-pyrrolyl, 2-pyrrolyl, 3-pyrrolyl, pyrazinyl, 2-pyridinyl, 3-pyridinyl, 4-pyridinyl, 1-indolyl, 2-indolyl, 3-indolyl, 4-indolyl, 5-indolyl, 6-indolyl, 7-indolyl, 1-isoindolyl, 2-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 9-carbazolyl, 1-phenanthrydinyl, 2-phenanthrydinyl, 3-phenanthrydinyl, 4-phenanthrydinyl, 6-phenanthrydinyl, 7-phenanthrydinyl, 8-phenanthrydinyl, 9-phenanthrydinyl, 10-phenanthrydinyl, 1-acrydinyl, 2-acrydinyl, 3-acrydinyl, 4-acrydinyl, 9-acrydinyl, 1,7-phenanthroline-2-yl, 1,7-phenanthroline-3-yl, 1,7-phenanthroline-4-yl, 1,7-phenanthroline-5-yl, 1,7-phenanthroline-6-yl, 1,7-phenanthroline-8-yl, 1,7-phenanthroline-9-yl, 1,7-phenanthroline-10-yl, 1,8-phenanthroline-2-yl, 1,8-phenanthroline-3-yl, 1,8-phenanthroline-4-yl, 1,8-phenanthroline-5-yl, 1,8-phenanthroline-6-yl, 1,8-phenanthroline-7-yl, 1,8-phenanthroline-9-yl, 1,8-phenanthroline-10-yl, 1,9-phenanthroline-2-yl, 1,9-phenanthroline-3-yl, 1,9-phenanthroline-4-yl, 1,9-phenanthroline-5-yl, 1,9-phenanthroline-6-yl, 1,9-phenanthroline-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthroline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthroline-1-yl, 2,8-phenanthroline-3-yl, 2,8-phenanthroline-4-yl, 2,8-phenanthroline-5-yl, 2,8-phenanthroline-6-yl, 2,8-phenanthroline-7-yl, 2,8-phenanthroline-9-yl, 2,8-phenanthroline-10-yl, 2,7-phenanthroline-1-yl, 2,7-phenanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 10-phenothiazinyl, 1-phenoxazinyl, 2-phenoxazinyl, 3-phenoxazinyl, 4-phenoxazinyl, 10-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrole-1-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl 1-indolyl, 4-t-butyl 1-indolyl, 2-t-butyl 3-indolyl, and 4-t-butyl 3-indolyl groups.

Examples of the substituted or unsubstituted alkyl groups with 1 to 50 carbon atoms include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihydroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diiodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminopropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitroisopropyl, 2,3-dinitro-t-butyl, 1,2,3-trinitropropyl, cyclopropyl, cyclobutyl, cyclopentyl, cyclohexyl, 4-methylcyclohexyl, 1-adamanthyl, 2-adamanthyl, 1-norbornyl, and 2-norbornyl groups.

The substituted or unsubstituted alkoxy groups with 1 to 50 carbon atoms are groups represented by -OY. Examples of Y include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihyroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diiodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminopropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitroisopropyl, 2,3-dinitro-t-butyl, and 1,2,3-trinitropropyl groups.

Examples of the substituted or unsubstituted aralkyl groups with 1 to 50 carbon atoms include benzyl, 1-phenylethyl, 2-phenylethyl, 1-phenylisopropyl, 2-phenylisopropyl, phenyl-t-butyl, α-naphthylmethyl, 1-α-naphthylethyl, 2-α-naphthylethyl, 1-α-naphthylisopropyl, 2-α-naphthylisopropyl, β-naphthylmethyl, 1-β-naphthylethyl, 2-β-naphthylethyl, 1-β-naphthylisopropyl, 2-β-naphthylisopropyl, 1-pyrrolylmethyl, 2-(1-pyrrolyl)ethyl, p-methylbenzyl, m-methylbenzyl, o-methylbenzyl, p-chlorobenzyl, m-chlorobenzyl, o-chlorobenzyl, p-bromobenzyl, m-bromobenzyl, o-bromobenzyl, p-iodobenzyl, m-iodobenzyl, o-iodobenzyl, p-hydroxybenzyl, m-hydroxybenzyl, o-hydroxybenzyl, p-aminobenzyl, m-aminobenzyl, o-aminobenzyl, p-nitrobenzyl, m-nitrobenzyl, o-nitrobenzyl, p-cyanobenzyl, m-cyanobenzyl, o-cyanobenzyl, 1-hydroxy-2-phenylisopropyl, and 1-chloro-2-phenylisopropyl groups.

The substituted or unsubstituted aryloxy groups with 5 to 50 nucleus atoms are represented by -OY'. Examples of Y' include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-pyrrolyl, 3-pyrrolyl, pyrazinyl, 2-pyridinyl, 3-pyridinyl, 4-pyridinyl, 2-indolyl, 3-indolyl, 4-indolyl, 5-indolyl, 6-indolyl, 7-indolyl, 1-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, 2-quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 1-phenanthrydinyl, 2-phenanthrydinyl,

3-phenanthrydinyl, 4-phenanthrydinyl, 6-phenanthrydinyl, 7-phenanthrydinyl, 8-phenanthrydinyl, 9-phenanthrydinyl, 10-phenanthrydinyl, 1-acrydinyl, 2-acrydinyl, 3-acrydinyl, 4-acrydinyl, 9-acrydinyl, 1,7-phenanthroline-2-yl, 1,7-phenanthroline-3-yl, 1,7-phenanthroline-4-yl, 1,7-phenanthroline-5-yl, 1,7-phenanthroline-6-yl, 1,7-phenanthroline-8-yl, 1,7-phenanthroline-9-yl, 1,7-phenanthroline-10-yl, 1,8-phenanthroline-2-yl, 1,8-phenanthroline-3-yl, 1,8-phenanthroline-4-yl, 1,8-phenanthroline-5-yl, 1,8-phenanthroline-6-yl, 1,8-phenanthroline-7-yl, 1,8-phenanthroline-9-yl, 1,8-phenanthroline-10-yl, 1,9-phenanthroline-2-yl, 1,9-phenanthroline-3-yl, 1,9-phenanthroline-4-yl, 1,9-phenanthroline-5-yl, 1,9-phenanthroline-6-yl, 1,9-phenanthrolirle-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthroline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthroline-1-yl, 2,8-phenanthroline-3-yl, 2,8-phenanthroline-4-yl, 2,8-phenanthroline-5-yl, 2,8-phenanthroline-6-yl, 2,8-phenanthroline-7-yl, 2,8-phenanthroline-9-yl, 2,8-phenanthroline-10-yl, 2,7-phenanthroline-1-yl, 2,7-phenanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 1-phenoxazinyl, 2-phenoxazinyl, 3-phenoxazinyl, 4-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrole-1-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl 1-indolyl, 4-t-butyl 1-indolyl, 2-t-butyl 3-indolyl, and 4-t-butyl 3-indolyl groups.

The substituted or unsubstituted arylthio groups with 5 to 50 nucleus atoms are represented by -SY", and examples of Y" include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-pyrrolyl, 3-pyrrolyl, pyrazinyl, 2-pyridinyl, 3-pyridinyl, 4-pyridinyl, 2-indolyl, 3-indolyl, 4-indolyl, 5-indolyl, 6-indolyl, 7-indolyl, 1-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, 2-quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 1-phenanthrydinyl, 2-phenanthrydinyl, 3-phenanthrydinyl, 4-phenanthrydinyl, 6-phenanthrydinyl, 7-phenanthrydinyl, 8-phenanthrydinyl, 9-phenanthrydinyl, 10-phenanthrydinyl, 1-acrydinyl, 2-acrydinyl, 3-acrydinyl, 4-acrydinyl, 9-acrydinyl, 1,7-phenanthroline-2-yl, 1,7-phenanthroline-3-yl, 1,7-phenanthroline-4-yl, 1,7-phenanthroline-5-yl, 1,7-phenanthroline-6-yl, 1,7-phenanthroline-8-yl, 1,7-phenanthroline-9-yl, 1,7-phenanthroline-10-yl, 1,8-phenanthroline-2-yl, 1,8-phenanthroline-3-yl, 1,8-phenanthroline-4-yl, 1,8-phenanthroline-5-yl, 1,8-phenanthroline-6-yl, 1,8-phenanthroline-7-yl, 1,8-phenanthroline-9-yl, 1,8-phenanthroline-10-yl, 1,9-phenanthroline-2-yl, 1,9-phenanthroline-3-yl, 1,9-phenanthroline-4-yl, 1,9-phenanthroline-5-yl, 1,9-phenanthroline-6-yl, 1,9-phenanthroline-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthroline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthroline-1-yl, 2,8-phenanthroline-3-yl, 2,8-phenanthroline-4-yl, 2,8-phenanthroline-5-yl, 2,8-phenanthroline-6-yl, 2,8-phenanthroline-7-yl, 2,8-phenanthroline-9-yl, 2,8-phenanthroline-10-yl, 2,7-phenanthroline-1-yl, 2,7-phenanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 1-phenoxazinyl, 2-phenoxazinyl, 3-phenoxazinyl, 4-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrole-1-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl 1-indolyl, 4-t-butyl 1-indolyl, 2-t-butyl 3-indolyl, and 4-t-butyl 3-indolyl groups.

The substituted or unsubstituted carboxyl groups with 1 to 50 carbon atoms are represented by -COOZ, and examples of Z include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihyroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diiodoethyl, 1,3-diiodoisopropyl, 2,3-diiado-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminapropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitroisopropyl, 2,3-dinitro-t-butyl, and 1,2,3-trinitropropyl groups.

Examples of the substituted or unsubstituted styryl groups include 2-phenyl-1-vinyl, 2,2-diphenyl-1-vinyl, and 1,2,2-triphenyl-1-vinyl groups.

Examples of the halogen groups include fluorine, chlorine, bromine and iodine.

1 is an integer of 1 to 5, preferably 1 to 2. m is an integer of 0 to 6, preferably 0 to 4.

$Ar^1$s may be the same as or different from each other when 1 is 2 or more, and Xs may be the same as or different from each other when m is 2 or more.

In the organic emitting layer, its emission capability can be improved by adding a fluorescent compound as a dopant. The dopant may be a dopant known as a luminescent material having a long lifetime. It is preferred to use, as the dopant material of the luminescent material, a material represented by the formula (2):

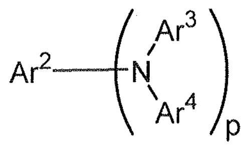

(2)

wherein $Ar^2$ to $Ar^4$ are each a substituted or unsubstituted aromatic group with 6 to 50 nucleus carbon atoms, or a substituted or unsubstituted styryl group; and p is an integer of 1 to 4.

Examples of the substituted or unsubstituted aromatic group with 6 to 50 nucleus carbon atoms include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-fluorenyl, 9,9-dimethyl-2-fluorenyl and 3-fluorantenyl groups.

Preferred examples thereof include phenyl, 1-naphthyl, 2-naphthyl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, o-tolyl, m-tolyl, p-tolyl, p-t-butylphenyl, 2-fluorenyl, 9,9-dimethyl-2-fluorenyl and 3-fluorantenyl groups.

Examples of the substituted or unsubstituted styryl group include 2-phenyl-1-vinyl, 2,2-diphenyl-1-vinyl, and 1,2,2-triphenyl-1-vinyl groups.

p is an integer of 1 to 4; provided that $Ar^3$s and $Ar^4$s, may be the same as or different from each other when p is 2 or more.

(6) Hole injecting/transporting layer

The hole injecting/transporting layer is a layer to help hole injection into an organic emitting layer and hole transfer into an emitting region. The hole injecting/transporting layer has a large hole mobility and a low ionization energy of usually 5.5 eV or less. The hole injecting/transporting layer is preferably made of a material that can transport holes to the organic emitting layer at a lower electric field intensity. Namely, the hole mobility thereof is preferably $10^{-4}$ $cm^2/V \cdot$second or more when an electric field of $10^4$ to $10^6$ V/cm is applied.

The material for forming the hole injecting/transporting layer can be arbitrarily selected from materials which have been widely used as a hole transporting material in photoconductive materials and known materials used in a hole injecting layer of EL devices.

Specific examples thereof include triazole derivatives (see USP No. 3,112,197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrozoline derivatives and pyrozolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3,526,501, and others), oxazole derivatives (ones disclosed in USP No. 3,257,203, and others), styrylanthracene derivatives (see

JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stylbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive macromolecular oligomers (in particular thiophene oligomers) disclosed in JP-A-1-211399.

The above substances can be used as the material of the hole-injecting layer. The following is preferably used: porphyrin compounds (disclosed in JP-A-63-2956965 and others), aromatic tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others), in particular, the aromatic tertiary amine compounds.
The following can also be given as examples: 4,4'-bis(N-(1-naphthyl)-N-phenylamino)biphenyl (hereinafter referred to as NPD), which has in the molecule thereof two condensed aromatic rings, disclosed in USP No. 5,061,569, and 4,4', 4"-tris(N-(3-methylphenyl)-N-phenylamino)triphenylamine (hereinafter referred to as hereinafter referred to as MTDATA), wherein three triphenylamine units are linked in a star-burst form, disclosed in JP-A-4-308688.

Inorganic compound such as p-type Si and p-type SiC, as well as the aromatic dimethylidene type compounds can also be used as the material of the organic emitting layer.

The hole injecting/transporting layer can be formed by making the above-mentioned compounds by a known method such as vacuum deposition, spin coating, casting or LB technique. The thickness thereof is not particularly limited, and is generally from 5 nm to 5 μm. This hole injecting/transporting layer may be made of a single layer or a stacked layers.

The organic semiconductor layer may be provided as a layer for helping the injection of holes or electrons into the emitting organic layer, and preferably has an electroconductivity of $10^{-10}$ S/cm or more. The material of such an organic semiconductor layer may be an electroconductive oligomer such as thiophene-containing oligomer or arylamine-containing oligomer disclosed in JP-A-8-193191, or an electroconductive dendrimer such as arylamine-containing dendrimer.

(7) Electron-transporting layer

An electron-transporting layer may be provided between the cathode and the emitting layer.
The thickness of electron-transporting layer may be properly selected from several nm to several μm but is preferably selected such that the electron mobility is $10^{-5}$ $cm^2/Vs$ or more when applied with an electric field of $10^4$ to $10^6$ V/cm.

The material used in the electron-transporting layer is preferably a metal complex of 8-hydroxyquincline or a derivative thereof.
Specific examples of the above-mentioned metal complex of 8-hydroxyquinoline or derivative thereof include metal chelate oxynoid compounds containing a chelate of oxine (generally, 8-quinolinol or 8-hydroxyquinoline).

For example, Alq as described regarding the emitting material can be used for the electron-injecting layer.

Examples of the oxadiazole derivative include electron-transferring compounds represented by the following general formulas.

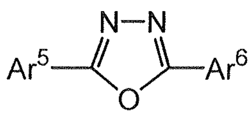

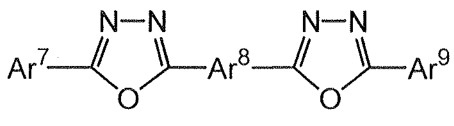

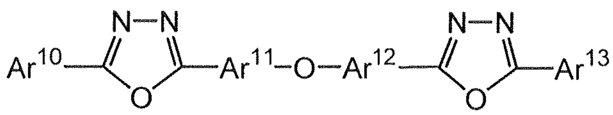

wherein $Ar^5$, $Ar^6$, $Ar^7$, $Ar^9$, $Ar^{10}$ and $Ar^{13}$ each represent a substituted or unsubstituted aryl group and may be the same or different, and $Ar^8$, $Ar^{11}$ and $Ar^{12}$ represent a substituted or unsubstituted arylene group and may be the same or different.

Examples of the aryl group include phenyl, biphenyl, anthranyl, perylenyl, and pyrenyl groups. Examples of the arylene group include phenylene, naphthylene, biphenylene, anthranylene, perylenylene, and pyrenylene groups. Examples of the substituent include alkyl groups with 1 to 10 carbon atoms, alkoxy groups with 1 to 10 carbon atoms,

and a cyano group. The electron-transferring compounds are preferably ones having capability of forming a thin film.

Specific examples of the electron-transferring compounds include the following.

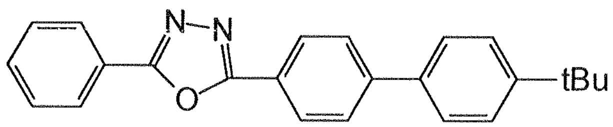

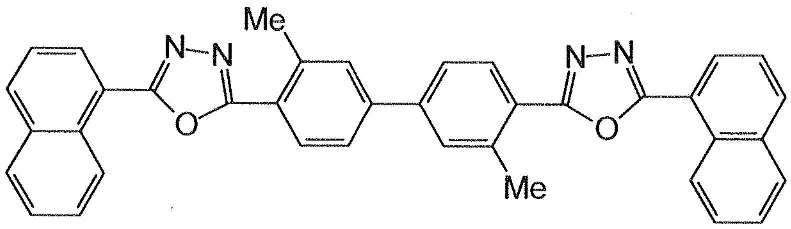

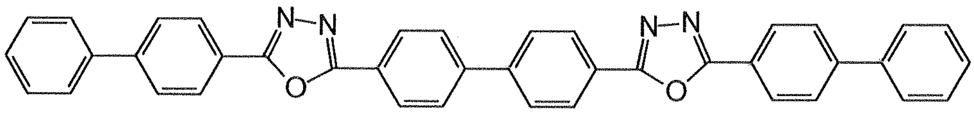

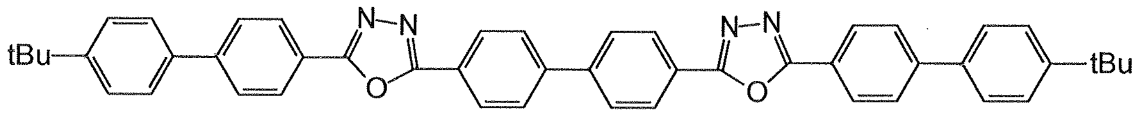

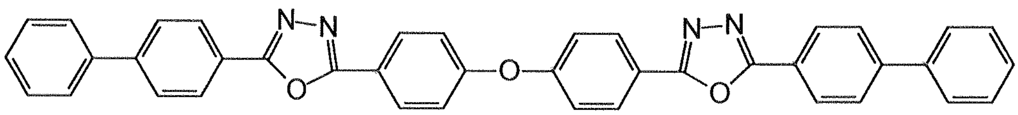

Examples of the semiconductor for forming the electron-transporting layer include oxides, nitrides or oxynitrides containing at least one element selected from Ba, Ca, Sr, Yb, Al, Ga, In, Li, Na, Cd, Mg, Si, Ta, Sb and Zn, and combinations of two or more thereof. For inorganic compounds forming the electron-transporting layer, preferred is a microcrystalline or amorphous insulative layer. If the electron-transporting layer is formed of the insulative layer, a more uniform thin film can be formed to reduce pixel defects such as dark spots. The inorganic compounds include alkali metal calcogenides, alkaline earth metal calcogenides, halides of alkali metals, halides of alkaline earth metals.

(8) Electron-injecting layer

The electron-injecting layer is a layer to help electron injection into the organic emitting layer and has a large electron movility. An adhesion improving layer is a particular electron-injecting layer made of a material enabling good adhesion to a cathode. Examples of electron-injecting compounds are given below.

Nitrogen-containing heterocyclic derivatives represented by the following formula, disclosed in Japanese patent application 2003-005184:

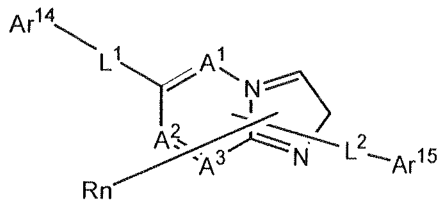

wherein $A^1$ to $A^3$ are a nitrogen atom or a carbon atom;

R is an aryl group having 6 to 60 carbon atoms which may have a substituent, a heteroaryl group having 3 to 60 carbon atoms which may have a substituent, an alkyl group having 1 to 20 carbon atoms, a haloalkyl group having 1 to 20 carbon atoms or an alkoxy group having 1 to 20 carbon atoms; n is an integer of 0 to 5; when n is an integer of 2 or more, Rs may be the same or different;

adjacent Rs may be bonded to each other to form a substituted or unsubstituted carbon aliphatic ring or a substituted or unsubstituted carbon aromatic ring;

$Ar^{14}$ is an aryl group having 6 to 60 carbon atoms which may have a substituent or a heteroaryl group having 3 to 60 carbon atoms which may have a substituent;

$Ar^{15}$ is a hydrogen atom, an alkyl group having 1 to 20 carbon atoms, a haloalkyl group having 1 to 20 carbon atoms, an alkoxy group having 1 to 20 carbon atoms, an aryl group having 6 to 60 carbon atoms which may have a substituent or a heteroaryl group having 3 to 60 carbon atoms which may have a substituent;

provided that one of $Ar^{14}$ and $Ar^{15}$ is a condensed ring having 10 to 60 carbon atoms which may have a substituent or a hetero condensed ring having 3 to 60 carbon atoms which may have a substituent; and

$L^1$ and $L^2$ are independently a single bond, a condensed ring having 6 to 60 carbon atoms which may have a substituent, a hetero condensed ring having 3 to 60 carbon atoms which may have a substituent or a fluorenylene group which may have a substituent.

Nitrogen-containing heterocyclic derivatives represented by the following formula, disclosed in Japanese patent application 2003-004193:

$$HAr\text{-}L^3\text{-}Ar^{16}\text{-}Ar^{17}$$

wherein HAr is a nitrogen-containing heterocyclic ring with 3 to 40 carbon atoms which may have a substituent; $L^3$ is a single bond, an arylene group with 6 to 60 carbon atoms which may have a substituent, a heteroarylene group with 3 to 60 carbon atoms which may have a substituent or a fluorenylene group which may have a substituent;

$Ar^{16}$ is a bivalent aromatic hydrocarbon group with 6 to 60 carbon atoms which may have a substituent; and

$Ar^{17}$ is an aryl group with 6 to 60 carbon atoms which may have a substituent or a heteroaryl group with 3 to 60 carbon atoms which may have a substituent.

An electroluminescent device using a silacyclopentadiene derivative represented by the following formula, disclosed in JP-A-09-087616:

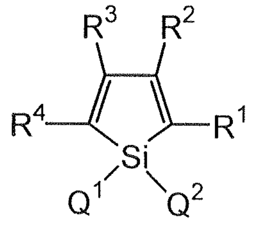

wherein $Q^1$ and $Q^2$ are each a saturated or unsaturated hydrocarbon group with 1 to 6 carbon atoms, an alkoxy group, an alkenyloxy group, an alkynyloxy group, a hydroxyl group, a substituted or unsubstituted aryl group, or a substituted or unsubstituted hetero ring, or $Q^1$ and $Q^2$ are bonded to each other to form a saturated or unsaturated ring; $R^1$ to $R^4$ are each a hydrogen atom, a halogen atom, a substituted or unsubstituted alkyl group with 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group,

an arylcarbonyloxy group, an alkoxycarbonyloxy group, an aryloxycarbonyloxy group, a sulfinyl group, a sulfonyl group, a sulfanyl group, a silyl group, a carbamoyl group, an aryl group, a heterocyclic group, an alkenyl group, an alkynyl group, a nitro group, a formyl group, a nitroso group, a formyloxy group, an isocyano group, a cyanate group, an isocyanate group, a thiocyanate group, an isothiocyanate group or a cyano group, or adjacent groups of $R^1$ to $R^4$ may be joined to form a substituted or unsubstituted condensed ring.

Silacyclopentadiene derivative represented by the following formula, disclosed in JP-A-09-194487:

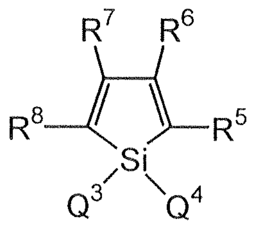

wherein $Q^3$ and $Q^4$ are each a saturated or unsaturated hydrocarbon group with 1 to 6 carbon atoms, an alkoxy group, an alkenyloxy group, an alkynyloxy group, a substituted or unsubstituted aryl group, or a substituted or unsubstituted heterocyclic group, or $Q^3$ and $Q^4$ are bonded to form a saturated or unsaturated ring; and $R^5$ to $R^8$ are each a hydrogen atom, a halogen atom, a substituted or unsubstituted alkyl group with 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group, an arylcarbonyloxy group, an alkoxycarbonyloxy group, an aryloxycarbonyloxy group, a sulfinyl group, a sulfonyl group, a sulfanyl group, a silyl group, a carbamoil group, an aryl group, a heterocyclic group, an alkenyl group, an alkynyl group, a nitro group, a formyl group, a nitroso group, a formyloxy group, an isocyano group, a cyanate group, an isocyanate group, a thiocyanate group, an isothiocyanate group or a cyano group, or adjacent groups of $R^5$ to $R^8$ are bonded to form a substituted or unsubstituted condensed ring structure: provided that in the case where $R^5$ and $R^8$ are each a phenyl group, $Q^3$ and $Q^4$ are neither an alkyl group nor a phenyl group; in the case where $R^5$ and $R^8$ are each a thienyl group, $Q^3$, $Q^4$, $R^6$ and $R^7$ do not form the structure where $Q^3$ and $Q^4$ are a monovalent hydrocarbon group, and at the same time $R^6$ and $R^7$ are an alkyl group, an aryl group, an alkenyl group, or $R^6$ and $R^7$ are aliphatic groups which form a ring by bonding to each other; in the case where $R^5$ and $R^8$ are a silyl group, $R^6$, $R^7$, $Q^3$ and $Q^4$ are each neither a monovalent hydrocarbon group with 1 to 6 carbon atoms nor a hydrogen atom; and in the case where a benzene ring is condensed at positions of $R^5$ and $R^6$, $Q^3$ and $Q^4$ are neither an alkyl group nor a phenyl group.

Borane derivatives represented by the following formula, disclosed in JP-A1-2000-040586:

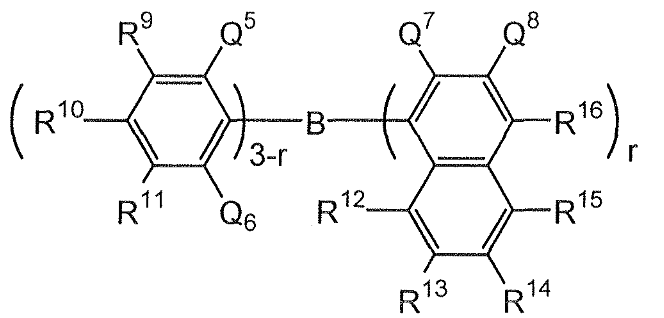

wherein $R^9$ to $R^{16}$ and $Q^8$ are each a hydrogen atom, a saturated or unsaturated hydrocarbon group, an aromatic group, a heterocyclic group, a substituted amino group, a substituted boryl group, an alkoxy group or an aryloxy group; $Q^5$, $Q^6$ and $Q^7$ are each a saturated or unsaturated hydrocarbon group, an aromatic group, a heterocyclic group, a substituted amino group, an alkoxy group or an aryloxy group; the substituents of $Q^7$ and $Q^8$ may be bonded to each other to form a condensed ring; r is an integer of 1 to 3, and $Q^7$S may be different from each other when r is 2 or more; provided that excluded are the compounds where r is 1, $Q^5$, $Q^6$ and $R^3$ are each a methyl group and $R^{16}$ is a hydrogen atom or a substituted boryl group, and the compounds where r is 3 and $Q^7$ is a methyl group.

Compounds represented by the following formula, disclosed in JP-A-10-088121:

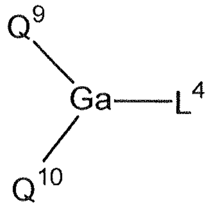

wherein $Q^9$ and $Q^{10}$ are independently a ligand represented by the following formula (3); and $L^4$ is a halogen atom, a substituted or unsubstituted alkyl group, a substituted or unsubstituted cycloalkyl group, a substituted or unsubstituted aryl group, a substituted or unsubstituted heterocyclic group, $-OR^{17}$ wherein $R^{17}$ is a hydrogen atom, a substituted or unsubstituted alkyl group, a substituted or unsubstituted cycloalkyl group, a substituted or unsubstituted aryl group or a substituted or unsubstituted heterocyclic group, or $-O-Ga-Q^{11}(Q^{12})$ wherein $_Q11$ and $Q^{12}$ are the same legands as $Q^9$ and $Q^{10}$.

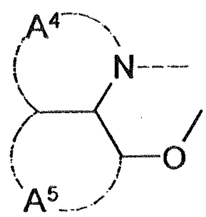

(3)

wherein rings $A^4$ and $A^5$ are each a 6-membered aryl ring structure which may have a substituent, and are condensed to each other.

The metal complexes have the strong nature of an n-type semiconductor and large ability of injecting electrons. Further the energy generated at the time of forming a complex is small so that a metal is strongly bonded to ligands in the complex formed and the fluorescent quantum efficiency becomes large as the emitting material.

Specific examples of the substituents of the rings $A^4$ and $A^5$ which form the ligands of the above formula include halogen atoms such as chlorine, bromine, iodine and fluorine; substituted or unsubstituted alkyl groups such as methyl, ethyl, propyl, butyl, sec-butyl, tert-butyl, pentyl, hexyl, heptyl, octyl, stearyl and trichloromethyl; substituted or unsubstituted aryl groups such as phenyl, naphthyl, 3-methylphenyl, 3-methoxyphenyl, 3-fluorophenyl, 3-trichloromethylphenyl, 3-trifluoromethylphenyl and 3-nitrophenyl; substituted or unsubstituted alkoxy groups such as methoxy, n-butoxy, tert-butoxy, trichloromethoxy, trifluoroethoxy, pentafluoropropoxy, 2,2,3,3-tetrafluoropropoxy, 1,1,1,3,3,3-hexafluoro-2-propoxy and 6-(perfluoroethyl)hexyloxy; substituted or unsubstituted aryloxy groups such as phenoxy, p-nitrophenoxy, p-tert-butylphenoxy, 3-fluorophenoxy, pentafluorophenyl and 3-trifluoromethylphenoxy; substituted or unsubstituted alkylthio groups such as methythio, ethylthio, tert-butylthio, hexylthio, octylthio and trifruoromethyltio; substituted or unsubstituted arylthio groups such as phenylthio, p-nitrophenylthio, p-tert-butylphenylthio, 3-fluorophenylthio, pentafluorophenylthio and 3-trifluoromethylphenylthio; a cyano group; a nitro group; an amino group; mono or di-substituted amino groups such as methylamino, dimethylamino, ethylamino, diethylamino, dipropylamino, dibutylamino and diphenylamino; acylamino groups such as bis(acetoxymethyl)amino, bis(acetoxyethyl)amino, bis(acetoxypropyl)amino and bis(acetoxybutyl)amino; a hydroxy group; a siloxy group; an acyl group; carbamoyl groups such as methylcarbamoyl, dimethylcarbamoyl, ethylcarbamoyl, diethylcarbamoyl, propylcarbamoyl, butylcarbamoyl and phenylcarbamoyl; a carboxylic group; a sulfonic acid group; an imido group; cycloalkyl groups such as cyclopentyl and cyclohexyl; aryl groups such as phenyl, naphthyl, biphenyl, anthranyl, phenanthryl, fluorenyl and pyrenyl; and heterocyclic groups such as pyridinyl, pyrazinyl, pyrimidinyl, pryidazinyl, triazinyl, indolinyl, quinolinyl, acridinyl, pyrrolidinyl, dioxanyl, piperidinyl, morpholidinyl, piperazinyl, triathinyl, carbazolyl, furanyl, thiophenyl, oxazolyl, oxadiazolyl, benzooxazolyl, thiazolyl, thiadiazolyl, benzothiazolyl, triazolyl, imidazolyl, benzoimidazolyl and puranyl. Moreover the above-mentioned substituents may be bonded to each other to form a six-membered aryl or heterocyclic ring.

In the invention, an electron-injecting layer which is formed of an insulator or a semiconductor may further be provided between a cathode and an organic layer. By providing such an electron-injecting layer, current leakage can be effectively prevented to improve the injection of electrons. As the insulator, the following is preferably used: at least one metal compound selected from the group consisting of alkali metal calcogenides, alkaline earth metal calcogenides,

halides of alkali metals and halides of alkaline earth metals. If the electron-injecting layer is formed of these alkali metal calcogenides and the like, its electron-injecting property can be preferably improved. Preferable alkali metal calcogenides include $Li_2O$, LiO, $Na_2S$, $Na_2Se$ and NaO. Preferable alkaline earth metal calcogenides include CaO, BaO, SrO, BeO, BaS and CaSe. Preferable halides of alkali metals include LiF, NaF, KF, LiCl, KCl and NaCl. Preferable halides of alkaline earth metals include fluorides such as $CaF_2$, $BaF_2$, $SrF_2$, $MgF_2$ and $BeF_2$ and halides other than fluorides.

(9) Reducing dopant

A reducing dopant is preferably contained in an electron transporting region or an interface region between a cathode and an organic layer. The reducing dopant is defined as a substance which can reduce electron-transporting compounds. Various substances having certain reducibility can be used. The following can be preferably used: at least one substance selected from alkali metals, alkaline earth metals, rare earth metals, oxides of alkali metals, halides of alkali metals, oxides of alkaline earth metals, halides of alkaline earth metals, oxides of rare earth metals, halides of rare earth metals, organic complexes of alkali metals, organic complexes of alkaline earth metals and organic complexes of rare earth metals.

Specifically preferable examples of the reducing dopant are at least one alkali metal selected from Na (work function: 2.36 eV), K (work function: 2.28 eV), Rb (work function: 2.16 eV) and Cs (work function: 1.95 eV) or at least one alkaline earth metal selected from Ca (work function: 2.9 eV), Sr (work function: 2.0 to 2.5 eV) and Ba (work function: 2.52 eV). Substances with a work function of 2.9 eV or less are particularly preferred. Among these, the reducing dopant is preferably at least one alkali metal selected from K, Rb and Cs, more preferably Rb or Cs, and most preferably Cs. These alkali metals have particularly high reducing ability. The luminance and lifetime of an organic EL device can be improved by adding a relatively small amount of these alkali metals to the electron-injecting region. As the reducing dopant with a work function of 2.9 eV or less, combinations of two or more of these alkali metals are preferable. Combinations with Cs, for example, Cs and Na, Cs and K, Cs and Rb, or Cs, Na and K are particularly preferable. The combination with Cs enables to efficiently exhibit the reducing ability and to improve the luminance and lifetime of an organic EL device by addition to the electron injecting region.

(10)Insulative layer

In an organic EL device, pixel defects due to leakage or a short circuit are easily generated since an electric field is applied to super thin films. In order to prevent this, it is preferred to insert an insulative thin layer between a pair of electrodes.

Examples of the material used in the insulative layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide.

In the invention, a mixture or laminate thereof may be used.

(11)Substrate

A glass plate, polymer plate and the like are preferably used as a substrate. Soda-lime glass, barium/strontium-containing glass, lead glass, aluminosilicate glass, borosilicate glass, barium borosilicate glass, quartz and the like are preferred as a glass plate. Polycarbonate, acrylic polymer, polyethylene terephthalate, polyethersulfide, polysulfone and the like are preferred as a polymer plate.

## Examples

### Example 1

An organic EL device shown in FIG. 7a was fabricated as follows.

A glass substrate 60 (25x75x1.1 mm) on which a Cr light reflecting electrode 61 (thickness: 50 nm) was formed in a certain pattern was subjected to ultrasonic cleaning for five minutes in isopropyl alcohol and then subjected to UV ozone cleaning for 30 minutes. The cleaned glass substrate provided with the light reflecting electrode was installed in a substrate holder of a vacuum deposition device, and an IZO film (non-emitting inorganic compound) was formed to a thickness of 320 nm (transparent electrode layer 62).

An N,N'-bis(N,N'-diphenyl-4-aminophenyl)-N,N-diphenyl-4,4'-diamino-1,1'-biphenyl film (hereinafter abbreviated as "TPD232 film") and a molybdenum trioxide film were formed at a weight ratio of 40:1 on the surface of the glass substrate on which the linear light reflecting electrode was formed so that the light reflecting electrode was covered. The

TPD232 film functioned as a hole injecting layer 63. A 4,4'-bis[N-(1-naphthyl)-N-phenylamino]-biphenyl film (hereinafter called "NPD film") was formed on the TPD232 film to a thickness of 60 nm. The NPD film functioned as a hole transporting layer 64. NPD and coumarin 6 were codeposited at a weight ratio of 40:1 to a thickness of 10 nm to form a green organic emitting layer 65. A styryl derivative DPVDPAN and a compound (B1) of the following formulas were deposited at a weight ratio of 40:1 to a thickness of 30 nm to form a blue organic emitting layer 66. Tris(8-quinolinol)aluminum (hereinafter abbreviated as "Alq") and DCJTB of the following formula were codeposited on the resulting film at a weight ratio of 100: 1 to a thickness of 20 nm to form a red organic emitting layer 67. After forming an Alq film to a thickness of 10 nm to form an electron transporting layer 68, Li (Li source: manufactured by SAES getters) and Alq were simultaneously deposited to form an Alq:Li film (thickness: 10 nm) as an electron injecting layer 69. Metal Ag was deposited on the Alq: Li film to a thickness of 5 nm to form a light semi-transmitting metal layer 70. An IZO film was then formed on the light semi-transmitting metal layer 70 to a thickness of 100 nm to form an electrode 71 to obtain an organic EL emitting device. The resulting device emitted white light with a luminance of 100 cd/$m^2$, an efficiency of 7 cd/A, and a maximum luminance of 80,000 cd/$m^2$ at a direct-current voltage of 5 V. The device formed using the above materials had CIE 1931 chromaticity coordinates of (x,y) = (0.30,0.32) (i.e. white).

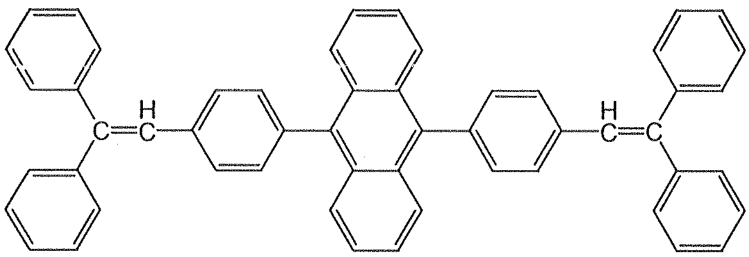

DPVDPAN

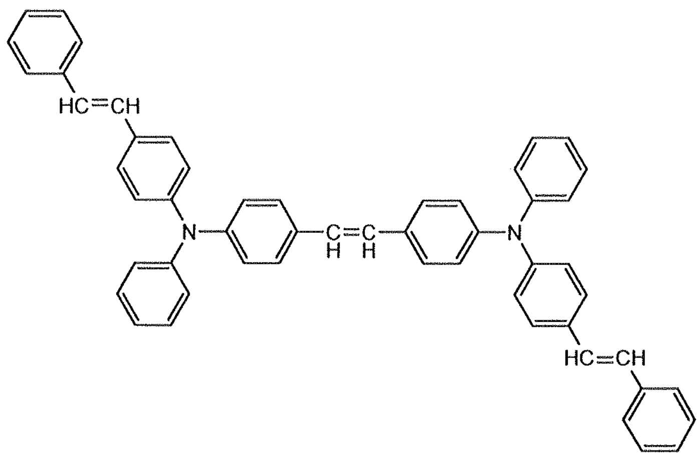

B1

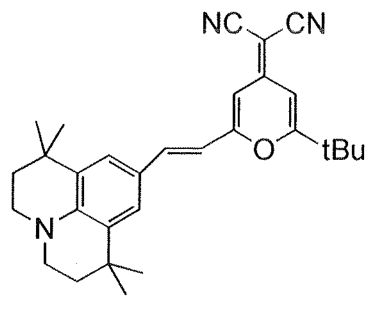

DCJTB

When applying light with a wavelength of 400 to 800 nm using a white light source (halogen lamp) from the side of the light semi-transmitting metal layer 70 (light semi-transmitting layer) in a state in which the organic EL device was not driven, the spectrum of the reflected light had minimum values at 435 nm (half-width: 25 nm), 510 nm (half-width: 40 nm), and 650 nm (half-width: 75 nm). The spectrum of the reflected light was measured using a spectroscope.
A glass plate provided with a blue color filter was placed on the device, and the emission properties were evaluated. The chromaticity coordinates were (x,y) = (0.15,0.10). A glass plate provided with a green color filter was placed on the device instead of the glass plate provided with a blue color filter, and the emission properties were evaluated. The chromaticity coordinates were (x,y) = (0.26,0.65). A glass plate provided with a red color filter was placed on the device instead of the glass plate provided with a green color filter, and the emission properties were evaluated. The chromaticity coordinates were (x,y) = (0.68,0.32).
The film thickness between the Cr film and the Ag film was 400 nm.

Comparative Example 1

An organic EL device shown in FIG. 7b was fabricated as follows.
The organic EL device was fabricated in the same manner as in Example 1 except that the IZO film (non-emitting inorganic compound) was not formed on the Cr film. The film thickness between the Cr film and the Ag film was 150 nm. The resulting device emitted white light with a luminance of 100 cd/$m^2$, an efficiency of 7 cd/A, and a maximum luminance of 80,000 cd/$m^2$ at a direct-current voltage of 5 V. The device formed using the above materials had CIE 1931 chromaticity coordinates of (x,y) = (0.30,0.32) (i.e. white).
When applying light with a wavelength of 400 to 800 nm from the side of the light semi-transmitting metal layer 70 (light semi-transmitting layer) in a state in which the organic EL device was not driven, the spectrum of the reflected light had two minimum values at 422 nm (half-width: 35 nm) and 671 nm (half-width: 210 nm).
The same glass plate provided with a blue color filter as in Example 1 was placed on the device, and the emission properties were evaluated. The chromaticity coordinates were (x,y) = (0.15, 0.12). Likewise, a glass plate provided with a green color filter was placed on the device, and the emission properties were evaluated. The chromaticity coordinates were (x,y) = (0.32,0.40). A glass plate provided with a red color filter was placed on the device, and the emission properties were evaluated. The chromaticity coordinates were (x,y) = (0.60,0.40).
The color purity after transmission through the color filter deteriorated in comparison with Example 1.

Example 2

An organic EL device shown in FIG. 7c was fabricated as follows.
Each layer was formed in the same manner as in Example 1, but the order of the layers was changed. Specifically, the films were formed in the order of Cr, Alq:Li, Alq, Alq:DCJTB, DPVDPAN:B1 NPD:Coumarin 6, NPD, and TDP232. A molybdenum trioxide film (transparent electrode layer 72) was formed on the TDP232 film to a thickness of 1 nm, and an IZO film (electrode protective layer 71) was formed on the molybdenum trioxide film to a thickness of 100 nm as a non-emitting inorganic compound layer. An $SiO_{(1-x)}N_x$ (x = 0 to 1) film was formed on the IZO film to a thickness of 200 nm as an insulating non-emitting inorganic compound layer 73. An Ag film was then formed thereon.
A metallic substance was not provided between the Cr film and the Ag film. The film thickness between the Cr film and the Ag film was 451 nm.
When applying light with a wavelength of 400 to 800 nm from the side of the light semi-transmitting metal layer 70 (light semi-transmitting layer) in a state in which the organic EL device was not driven, the spectrum of the reflected light had minimum values at 442 nm (half-width: 20 nm), 494 nm (half-width: 30 nm), 580 nm (half-width: 45 nm), and 730 nm (half-width: 80 nm).
The same glass plate provided with a blue color filter as in Example 1 was placed on the device, and the emission properties were evaluated. The chromaticity coordinates were (x,y) = (0.15,0.10). Likewise, a glass plate provided with a green color filter was placed on the device, and the emission properties were evaluated. The chromaticity coordinates were (x,y) = (0.26,0.67). A glass plate provided with a red color filter was placed on the device, and the emission properties were evaluated. The chromaticity coordinates were (x,y) = (0.68,0.32).

Comparative Example 2

An organic EL device shown in FIG. 7d was fabricated as follows.
The organic EL device was fabricated in the same manner as in Example 2 except that the $SiO_{(1-x)}N_x$ film was not formed and the IZO film and the Ag film were interchanged.
The film thickness between the Cr film and the Ag film was 151 nm.
The same glass plate provided with a blue color filter as in Example 1 was placed on the device, and the

emission properties were evaluated. The chromaticity coordinates were (x,y) = (0.15,0.18). Likewise, a glass plate provided with a green color filter was placed on the device, and the emission properties were evaluated. The chromaticity coordinates were (x,y) = (0.32,0.40). A glass plate provided with a red color filter was placed on the device, and the emission properties were evaluated. The chromaticity coordinates were (x,y) = (0.58,0.42).
The color purity after transmission through the color filter deteriorated in comparison with Example 1.

Industrial Utility

The organic EL device according to the invention may be used for various displays (e.g. consumer and industrial displays such as monochrome and full-color displays for portable telephones, PDAs, car navigation systems, monitors, and TVs), various types of lighting (e.g. backlight), and the like.

## Claims

**1.** An organic electroluminescent device comprising:

a light reflecting layer,
a light semi-transmitting layer and
a light interference part including an organic emitting layer, the part being formed between the light reflecting layer and the light semi-transmitting layer;
the spectrum of reflected light emitted from the light semi-transmitting layer having at least three minimum values in the wavelength region of 400 to 800 nm when light having a wavelength of 400 to 800 nm enters from the light semi-transmitting layer.

**2.** The organic electroluminescent device according to claim 1, wherein at least one of the light reflecting layer and the light semi-transmitting layer is a drive electrode.

**3.** The organic electroluminescent device according to claim 1, wherein the light reflecting layer is a reflective electrode.

**4.** The organic electroluminescent device according to claim 1, wherein the light interference part comprises at least one of,
a first inorganic compound layer between the light reflecting layer and the organic emitting layer and,
a second inorganic compound layer between the organic emitting layer and the light semi-transmitting layer.

**5.** The organic electroluminescent device according to claim 4, wherein at least one of the first and second inorganic compound layers is a transparent electrode.

**6.** The organic electroluminescent device according to claim 1, wherein the light semi-transmitting layer is provided with a light diffusion part.

**7.** An organic electroluminescent device comprising:

a first light semi-transmitting layer,
a second light semi-transmitting layer and
a light interference part including an organic emitting layer, the part being formed between the first light semi-transmitting layer and the second light semi-transmitting layer;
the spectrum of transmitted light emitted from the first light semi-transmitting layer having at least three maximum values in the wavelength region of 400 to 800 nm when light having a wavelength of 400 to 800 nm enters from the second light semi-transmitting layer.

**8.** The organic electroluminescent device according to claim 7, wherein at least one of the first light semi-transmitting layer and the second light semi-transmitting layer is a drive electrode.

**9.** The organic electroluminescent device according to claim 7, wherein the light interference part comprises at least one of,
a first inorganic compound layer between the first light semi-transmitting layer and the organic emitting layer and,
a second inorganic compound layer between the organic emitting layer and the second light semi-transmitting layer.

**10.** The organic electroluminescent device according to claim 9, wherein at least one of the first and second inorganic compound layers is a transparent electrode.

**11.** The organic electroluminescent device according to claim 7, wherein at least one of the first and second light semi-transmitting layers is provided with a light diffusion part.

**12.** A display comprising a color conversion member and the organic electroluminescent device according to claim 1 or 7.

**13.** A display comprising a color filter and the organic electroluminescent device according to claim 1 or 7.

FIG.1

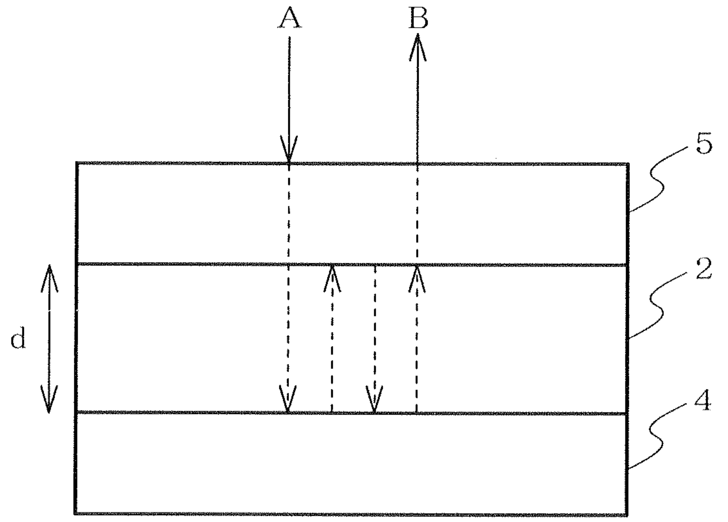


FIG.2

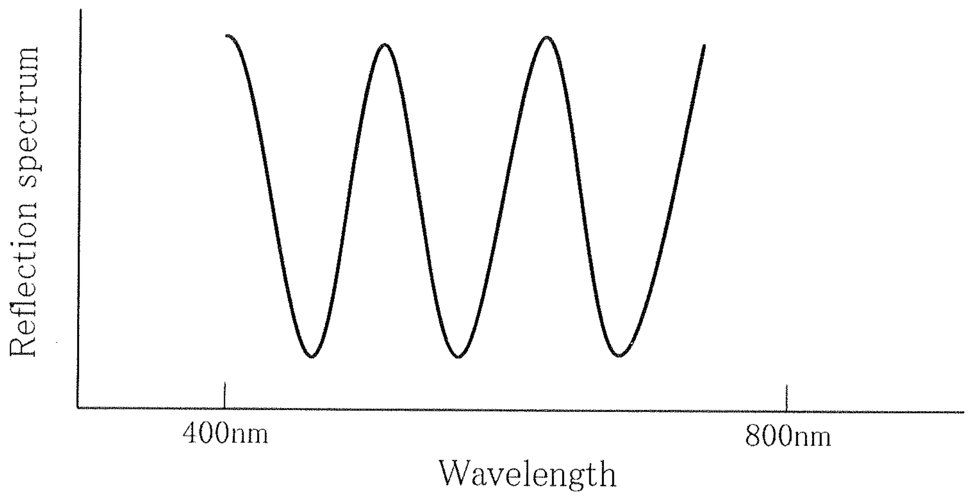

FIG.3(a)

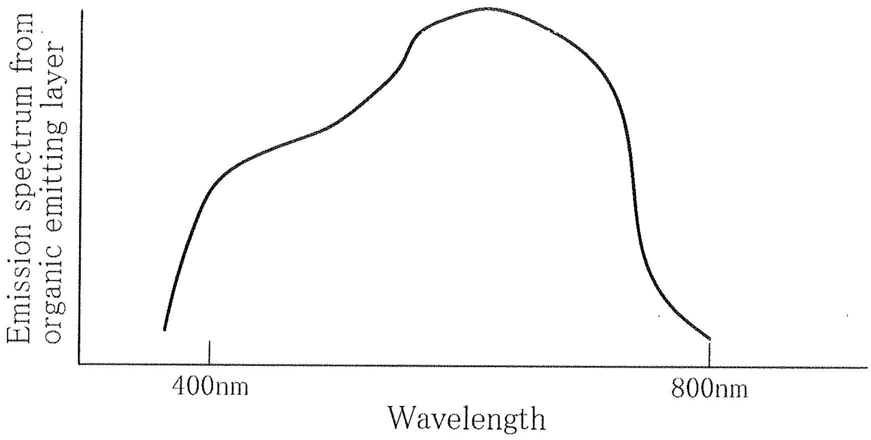


FIG.3(b)

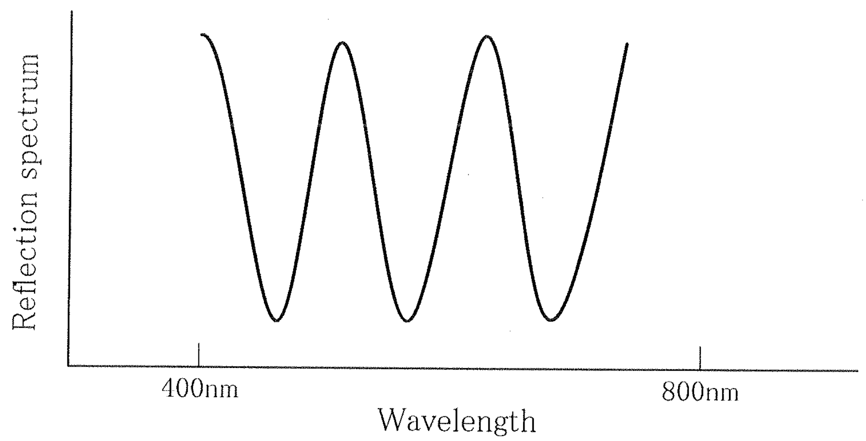


FIG.3(c)

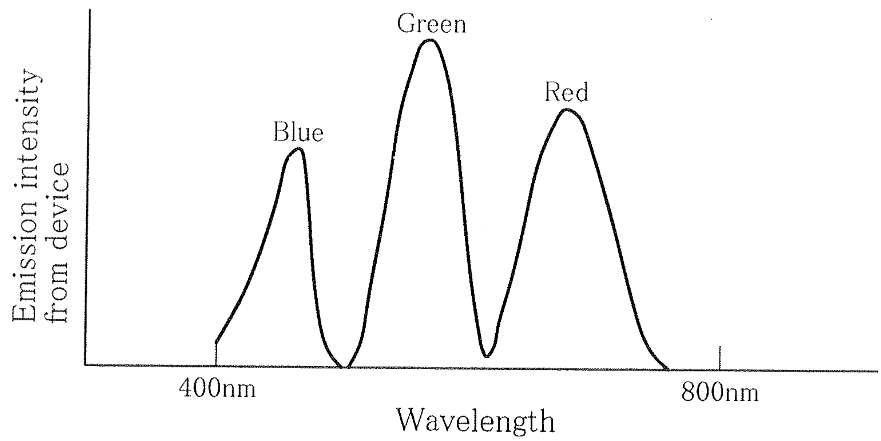

FIG. 4a

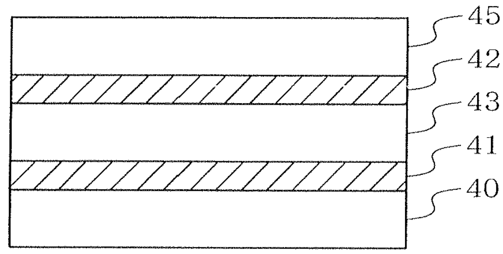


FIG. 4b

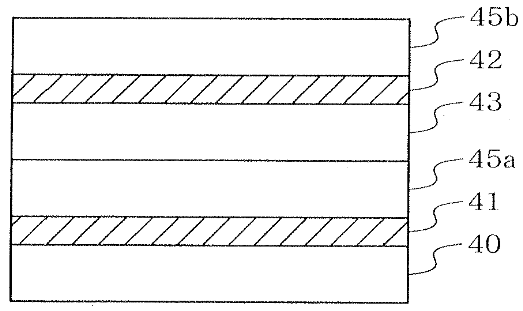


FIG. 4c

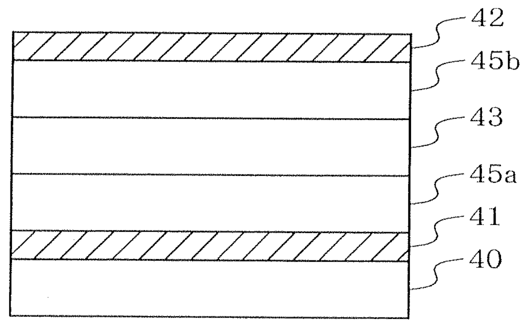


FIG. 4d

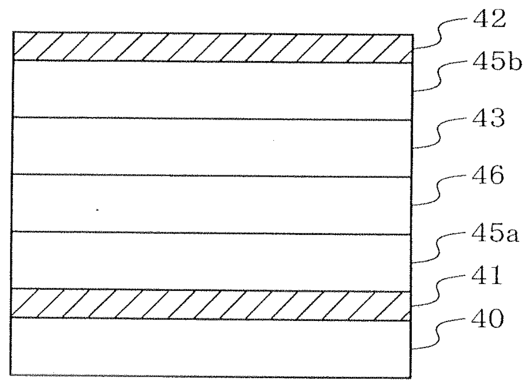

FIG. 4e

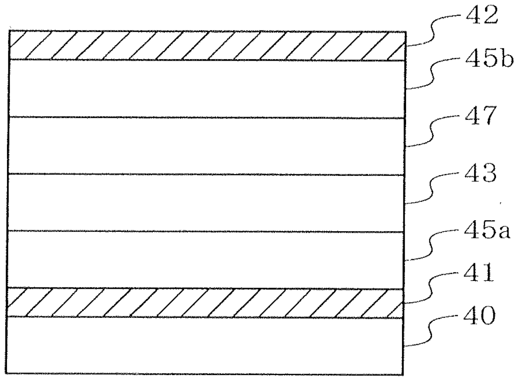


FIG. 4f

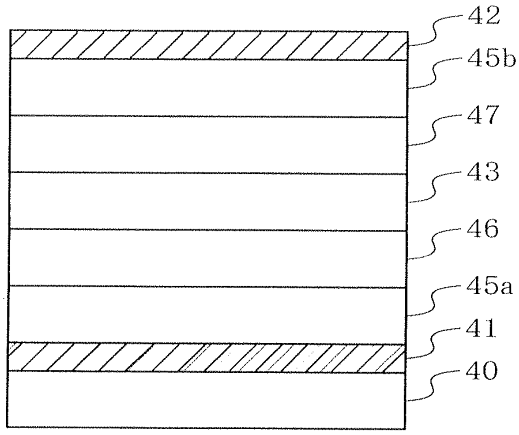


FIG. 4g

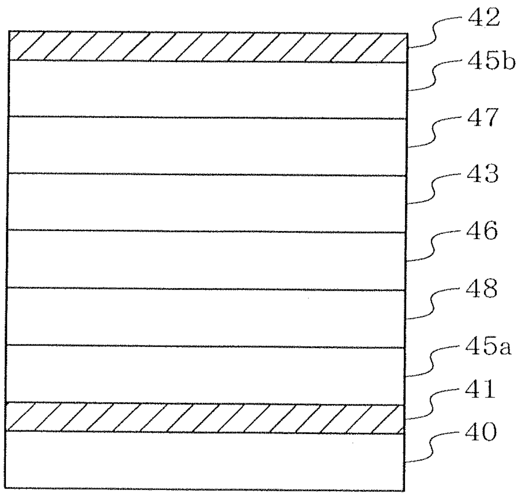

FIG. 4h

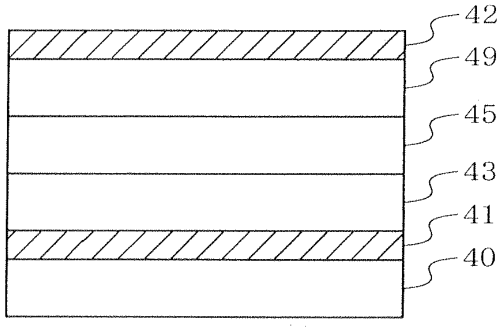


FIG. 4i

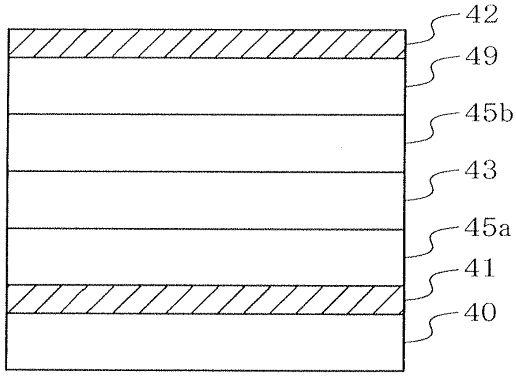


FIG. 4j

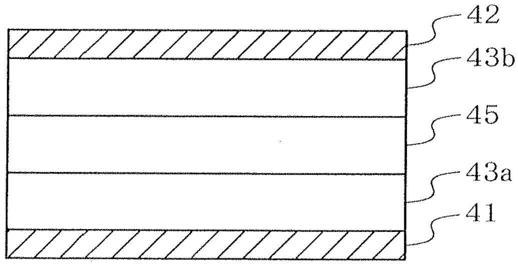


FIG. 4k

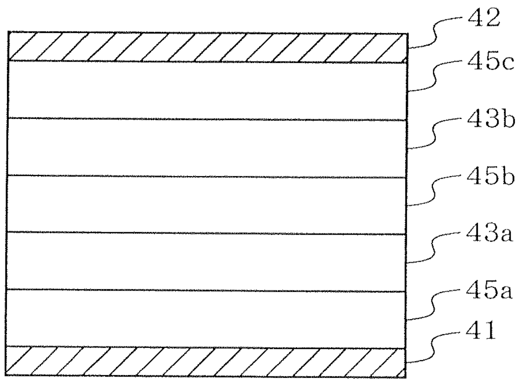

FIG.5

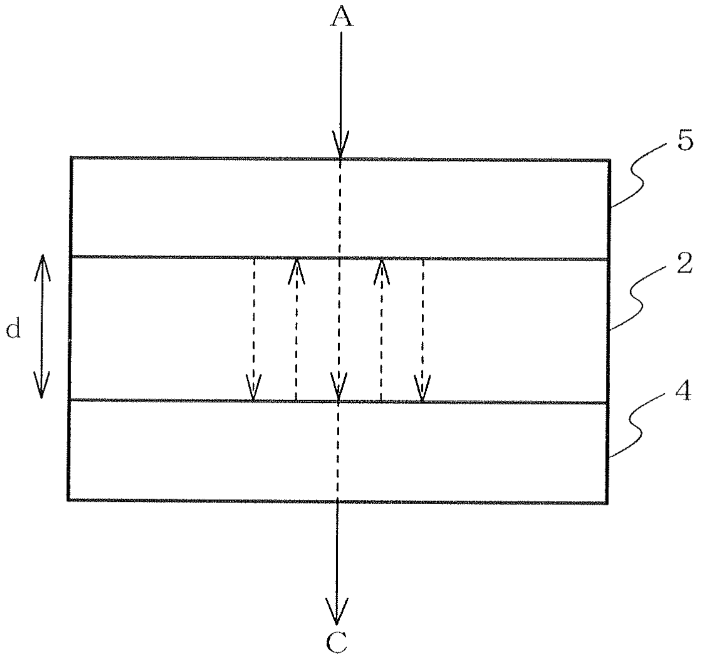
A
5
2
d
4
C

FIG.6

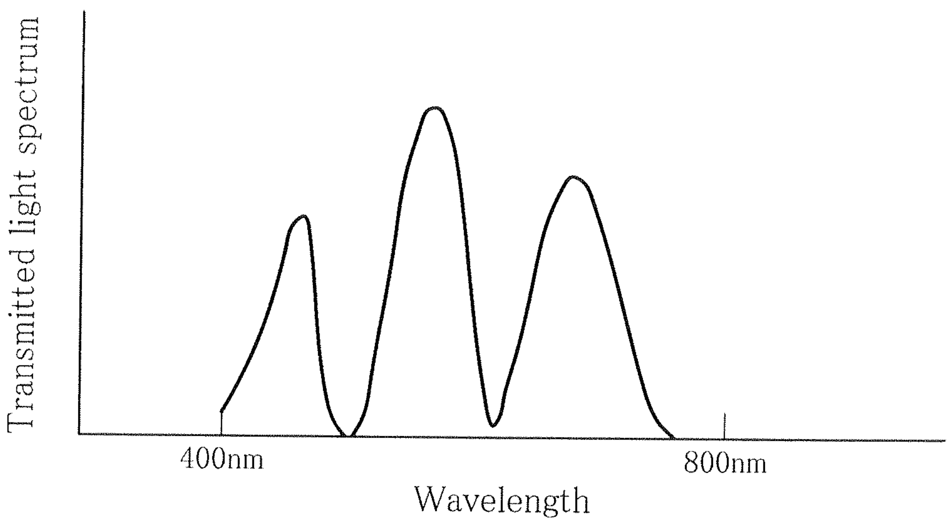
Transmitted light spectrum
400nm
800nm
Wavelength

FIG. 7a

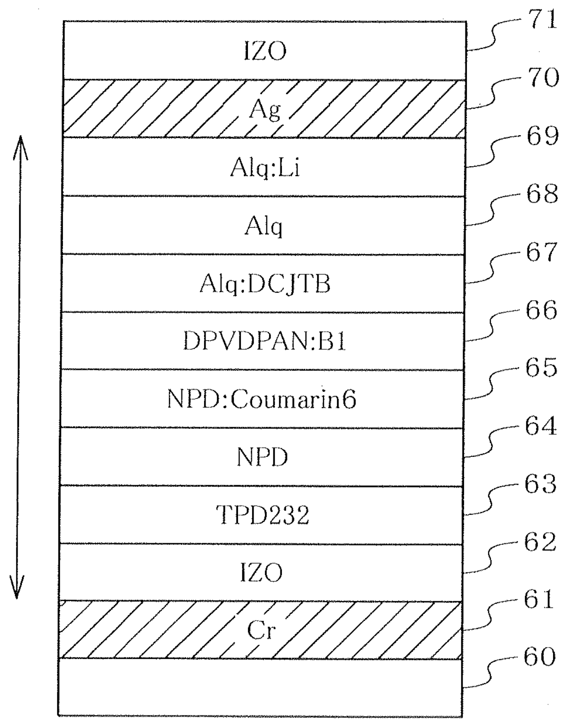
IZO
Ag
Alq:Li
Alq
Alq:DCJTB
DPVDPAN:B1
NPD:Coumarin6
NPD
TPD232
IZO
Cr
71
70
69
68
67
66
65
64
63
62
61
60

FIG. 7b

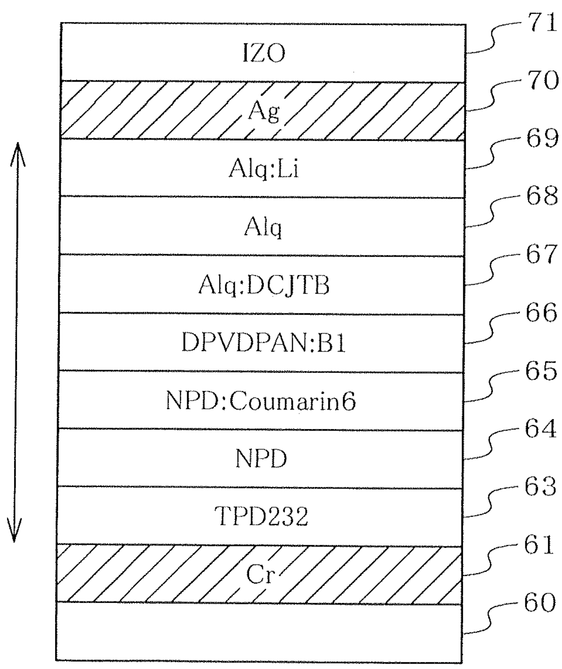
IZO
Ag
Alq:Li
Alq
Alq:DCJTB
DPVDPAN:B1
NPD:Coumarin6
NPD
TPD232
Cr
71
70
69
68
67
66
65
64
63
61
60

FIG. 7c

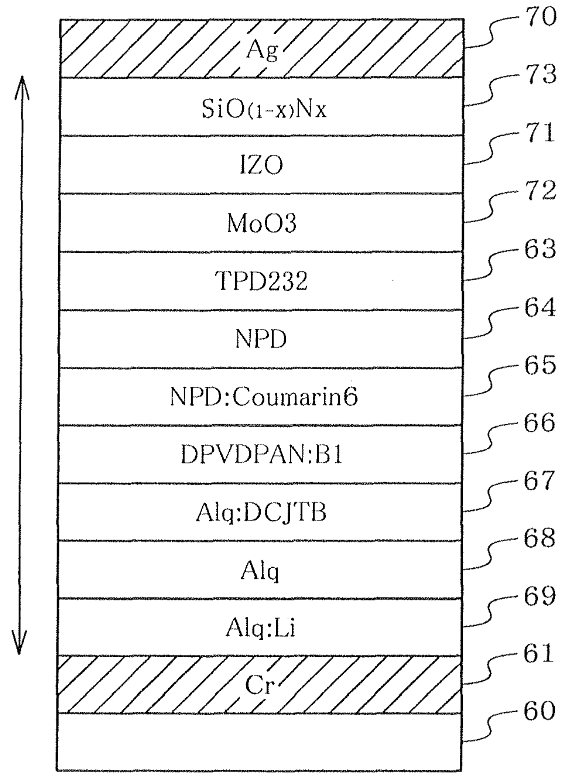
Ag
SiO(1-x)Nx
IZO
MoO3
TPD232
NPD
NPD:Coumarin6
DPVDPAN:B1
Alq:DCJTB
Alq
Alq:Li
Cr
70
73
71
72
63
64
65
66
67
68
69
61
60

FIG. 7d

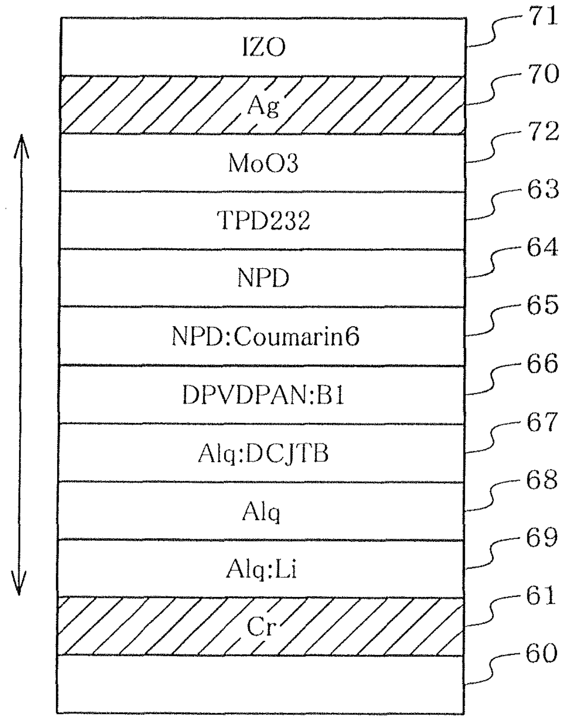
IZO
Ag
MoO3
TPD232
NPD
NPD:Coumarin6
DPVDPAN:B1
Alq:DCJTB
Alq
Alq:Li
Cr
71
70
72
63
64
65
66
67
68
69
61
60

## INTERNATIONAL SEARCH REPORT

International application No.
PCT/JP2005/003733

A. CLASSIFICATION OF SUBJECT MATTER
Int.Cl[7] H05B33/24, 33/12, 33/14

According to International Patent Classification (IPC) or to both national classification and IPC

B. FIELDS SEARCHED

Minimum documentation searched (classification system followed by classification symbols)
Int.Cl[7] H05B33/24, 33/12, 33/14

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 7-320864 A (AT & T Corp.),<br>08 December, 1995 (08.12.95),<br>Full text; all drawings<br>& EP 683623 A1 & US 5478658 A<br>& DE 69510863 E | 1-6<br>12-13 |
| A | WO 01/039554 A1 (Sony Corp.),<br>31 May, 2001 (31.05.01),<br>Mode 4; Fig. 20<br>& EP 1154676 A1 & KR 2001101640 A<br>& TW 466889 A | 1-13 |
| Y | JP 2003-272855 A (Fuji Electric Co., Ltd.),<br>26 September, 2003 (26.09.03),<br>Par. No. [0044]<br>(Family: none) | 12-13 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 06 April, 2005 (06.04.05) | 26 April, 2005 (26.04.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

International application No.
PCT/JP2005/003733

C (Continuation). DOCUMENTS CONSIDERED TO BE RELEVANT

| Category* | Citation of document, with indication, where appropriate, of the relevant passages | Relevant to claim No. |
|---|---|---|
| A | JP 6-283271 A (Ricoh Co., Ltd.), 07 October, 1994 (07.10.94), Full text; all drawings (Family: none) | 1-13 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2001039554 A
- JP H14373776 A
- JP 57051781 A
- US 3112197 A
- US 3189447 A
- JP 3716096 B
- US 3615402 A
- US 3820989 A
- US 3542544 A
- JP 45555 B
- JP 51010983 B
- JP 51093224 A
- JP 55017105 A
- JP 56004148 A
- JP 55108667 A
- JP 55156953 A
- JP 56036656 A
- US 3180729 A
- US 4278746 A
- JP 55088064 A
- JP 55088065 A
- JP 49105537 A
- JP 55051086 A
- JP 56080051 A
- JP 56088141 A
- JP 57045545 A
- JP 54112637 A
- JP 55074546 A
- US 3615404 A
- JP 51010105 B
- JP 46003712 B
- JP 47025336 B
- JP 54053435 A
- JP 54110536 A
- JP 54119925 A
- US 3567450 A
- US 3180703 A
- US 3240597 A
- US 3658520 A
- US 4232103 A
- US 4175961 A
- US 4012376 A
- JP 49035702 B
- JP 3927577 B
- JP 55144250 A
- JP 56119132 A
- JP 56022437 A
- DE 1110518
- US 3526501 A
- US 3257203 A
- JP 56046234 A
- JP 54110837 A
- US 3717462 A
- JP 54059143 A
- JP 55052063 A
- JP 55052064 A
- JP 55046760 A
- JP 55085495 A
- JP 57011350 A
- JP 57148749 A
- JP 2311591 A
- JP 61210363 A
- JP 61228451 A
- JP 61014642 A
- JP 61072255 A
- JP 62047646 A
- JP 62036674 A
- JP 62010652 A
- JP 62030255 A
- JP 60093455 A
- JP 60094462 A
- JP 60174749 A
- JP 60175052 A
- US 4950950 A
- JP 2204996 A
- JP 2282263 A
- JP 1211399 A
- JP 632956965 A
- US 4127412 A
- JP 53027033 A
- JP 54058445 A
- JP 54149634 A
- JP 54064299 A
- JP 55079450 A
- JP 61295558 A
- JP 61098353 A
- JP 63295695 A
- US 5061569 A
- JP 4308688 A
- JP 8193191 A
- JP 2003005184 A
- JP 2003004193 A
- JP 9087616 A
- JP 9194487 A
- JP 2000040586 A
- JP 10088121 A